# EUROPEAN PATENT APPLICATION

(11) **EP 1 087 445 A1**
(43) Date of publication of application: **28.03.2001**
(21) Application number: 99900292.6
(22) Date of filing: 13.01.1999
(51) Int. Cl.: H01L 29/84, G01L 9/04, G01P 15/12, G01P 15/125

(54) **INERTIA FORCE SENSOR AND METHOD FOR PRODUCING INERTIA FORCE SENSOR**

(71) Applicant: MITSUBISHI DENKI KABUSHIKI KAISHA, Tokyo 100-8310 (JP)
(72) Inventor: OHJI, Hiroshi Mitsubishi Denki Kabushiki Kaisha, Tokyo 100-8310 (JP); TSUTSUMI, Kaz. Mitsubishi Denki Kabushiki Kaisha, Tokyo 100-8310 (JP); FRENCH, Patrick, J., NL-2625 KS Delft (NL)
(74) Representative: Sajda, Wolf E., Dipl.-Phys.
(86) International application number: JP9900078
(87) International publication number: WO0042666

(57) **Abstract**

An inertia force sensor having a mass body (11) which moves when force is applied to the sensor, at least one holding beam (12) for holding the mass body (11), and an anchor portion (13) for fixing an end portion of the holding beam (12), the sensor being designed to detect inertia force, which acts on the mass body (11), on the basis of a movement of the mass body (11). The sensor is characterized in that the mass body (11) is composed of a free standing structure (9) which is formed by removing an inner part of a silicon substrate (1) therefrom by means of an etching process within a single step, and the anchor portion (13) is composed of at least a part of a main body of the silicon substrate. Because the inertia force sensor is composed of single crystal silicon, its mechanical properties and reliability may be highly improved.

## Description

### Technical Field

The present invention relates to an inertia force sensor for measuring inertia force caused by acceleration, angular velocity or the like, and relates to a manufacturing method thereof. In particular, it relates to the inertia force sensor having a movable mass body to which inertia force is exerted and at least one beam for holding the movable mass body, which detects deflection of the beam caused by change of the inertia force exerted to the movable mass body, to thereby measure the inertia force on the basis of the amount of the deflection, and relates to the manufacturing method thereof.

### Background Art

There has been well-known an inertia force sensor having a movable mass body and a beam in which one end is joined with the movable mass body while the other end is joined with an anchor portion, which detects deflection (deformation) caused in the beam by inertia force exerted to the movable mass body, to thereby detect the inertia force on the basis of the amount of the deflection. Hereupon, the anchor portion is fixed to a certain object (for example, automobile etc.) on which the inertia force sensor is mounted. Generally, in the above-mentioned inertia force sensor, in which a piezoresistor is disposed on a surface of the beam, deformation is caused in the piezoresistor due to the deflection caused in the beam. In consequence, the amount of the deflection or the beam, namely the inertia force exerted to the movable mass body, is detected on the basis of the resistance of the piezoresistor while utilizing such a phenomenon that the resistance varies in accordance with the deformation. Hereupon, because the inertia force detected by the inertia force sensor described above is proportional to acceleration, angular velocity or the like, caused in the object on which the inertia force sensor is mounted, the inertia force sensor is broadly used for a car body controller or safety sensor of an automobile, as an acceleration sensor (accelerometer), an angular velocity sensor or the like, up to now.

Hereupon, the structural part including the movable mass body, the beam and the anchor portion, which constitutes the main portion of the above-mentioned inertia force sensor, is generally composed of a silicon device which is fabricated by processing a silicon substrate. Hereinafter, some conventional silicon devices used for the main portions of the inertia force sensors or manufacturing processes thereof will be described.

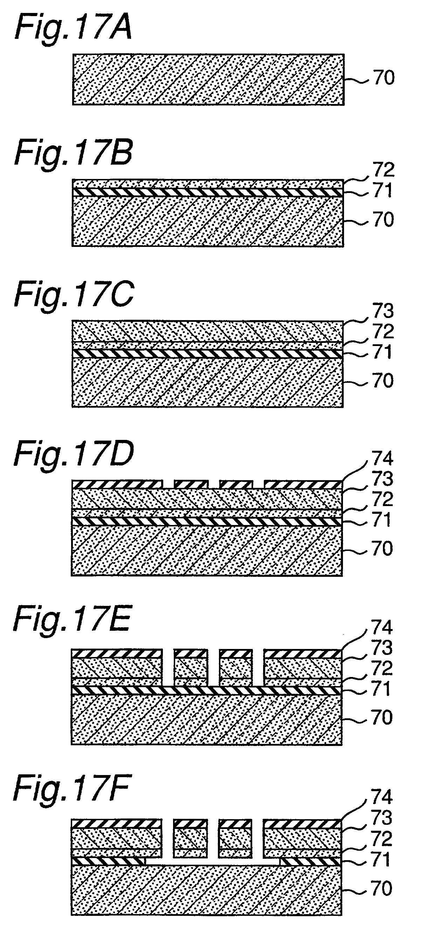

Figs. 17A to 17F are views showing a conventional manufacturing process for fabricating a device having a movable portion (movable mass body) on a silicon substrate. According to the manufacturing process, a plate-shaped silicon substrate 70 is prepared, at first, as shown in Fig. 17A. Next, as shown in Fig. 17B, a first oxide film 71, which is to be used as a sacrificial layer, is formed on the silicon substrate 70 by means of the CVD technique or the like, and then a first polysilicon film 72, which is to be used as a seed layer, is formed on the oxide film by means of the low pressure CVD technique or the like. After that, as shown in Fig. 17C, a second polysilicon film 73, which is to become a structural part, is formed on the first polysilicon film 72 using an epitaxial reactor. Further, after the second polysilicon film 73 of a desired thickness has been obtained, as shown in Fig. 17D, a second oxide film 74 as the uppermost layer is formed on the second polysilicon film 73 by means of the CVD technique or the like, and then the second oxide film 74 is subjected to a patterning treatment so as to obtain the structural part of the desired shape. The patterned second oxide film 74 is used as a mask for etching the first and second polysilicon films 72,73 which are to become the structural part thereunder. Next, as shown in Fig. 17E, an etching treatment is performed to the first polysilicon film 72 and the second polysilicon film 73 by means of the reactive ion etching technique or the like till the etching reaches the first oxide film 71. Further, as shown in Fig. 17F, a part of the first oxide film 71, which is located under the first polysilicon film 72, is removed by using hydrofluoric acid or the like. In consequence, there is obtained a movable portion which is substantially composed of the first polysilicon film 72 and the second polysilicon film 73.

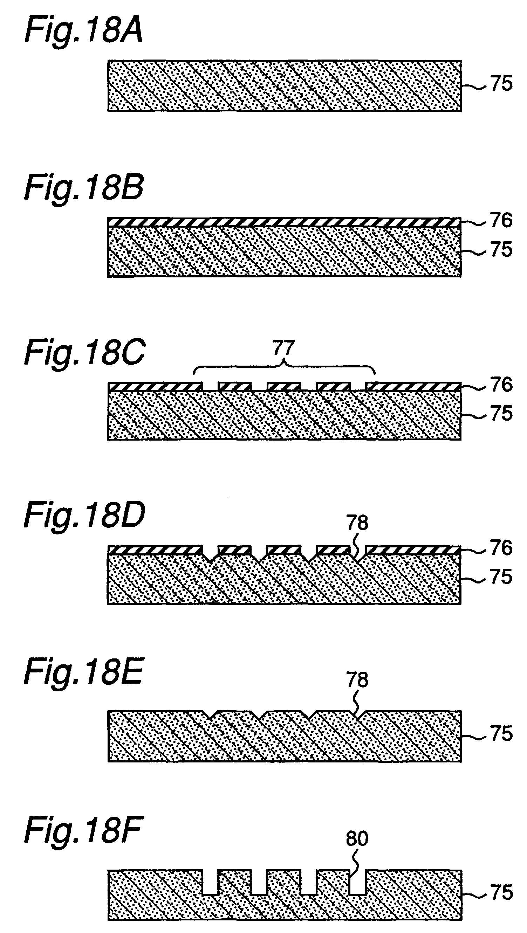

Figs. 18A to 18F are views showing another conventional manufacturing process of a silicon device, which is disclosed, for example, in pages 189 to 197 of Volume 3223 of "Proceedings SPIE Micromachining and Microfabrication Process Technology III" published at Austin in Texas (U.S.A.) on September in 1997. According to the manufacturing process of the silicon device, as shown in Fig. 18A, at first, a plate-shaped n-type silicon substrate 75 is prepared. Further, as shown in Fig. 18B, a silicon nitride film 76 is formed on a surface of the silicon substrate 75. Following that, as shown in Fig. 18C, the silicon nitride film 76 is patterned by means of the photolithography technique so that a pattern 77 is formed. Next, as shown in Fig. 18D, pits 78 with inverted triangle shapes are formed on the silicon substrate 75 using KOH. Moreover, the silicon nitride film 76, which has been used as a mask for the etching using KOH, is removed so that the silicon substrate 75 having the pits 78 as shown in Fig. 18E is obtained. Then, as shown in Fig. 18F, a voltage is applied to the silicon substrate 75 while the silicon substrate 75 is immersed in a hydrofluoric acid aqueous solution, with the silicon substrate used a positive electrode. In addition, light is applied to the silicon substrate 75 so that the silicon substrate is etched in the direction depthwise of the substrate. Thus, grooves 80 are formed in the silicon substrate 75.

However, in the inertia force sensor using the above-mentioned conventional silicon device, in which the free standing structure as the movable portion is composed of polysilicon, there is such a problem that the mechanical properties and the reliability are inferior to those of one formed of single crystal silicon. Further, there is such a problem that because it is impossible to sufficiently enlarge the gap between the movable portion and the substrate thereunder for reason of its manufacturing process, the movable portion and the substrate may interfere to each other. Further, there is such a problem that the manufacturing process is complicated. In consequence, there is such a problem that it is impossible to obtain an inertia force sensor with high reliability at a low cost.

Moreover, the current is concentrated at the boundary region between the anchor portion and the cantilever, when the cantilever is fabricated by such a process that after the etching start patterns have been formed on the silicon substrate or the surface of the silicon substrate, a voltage is applied to etch the substrate in the direction depthwise of the substrate while the silicon substrate is immersed in the solution containing fluorine ions, with the silicon substrate used a positive electrode. In consequence, there is such a problem that it is impossible to form structural parts having shapes as same as those of the etching start patterns. Moreover, in the above-mentioned etching process, there is such a problem that it is impossible to etch the substrate having a larger surface.

### Disclosure of Invention

The present invention has been developed to solve the above-mentioned conventional problems, and has an object of providing a low-priced inertia force sensor with high reliability or a manufacturing method thereof, which is capable of forming a free standing structure composed of single crystal silicon by a single step, and enlarging the gap between the free standing structure and the substrate sufficiently. In addition, it also has another object of providing an inertia force sensor with high reliability which has structural parts having shapes as same as those of desired etching start patterns, or a manufacturing method thereof.

An inertia force sensor according to an aspect of the present invention, which has been developed to achieve the above-mentioned object, is characterized in that it includes a mass body which moves when force is applied to the sensor, at least one holding beam for holding the mass body, and an anchor portion for fixing an end portion of the holding beam, the sensor being designed to detect inertia force, which acts on the mass body, on the basis of a movement of the mass body, wherein the mass body is composed of a free standing structure which is formed by removing an inner part of a silicon substrate therefrom by means of an etching process, and the anchor portion is composed of at least a part of a main body of the silicon substrate.

In the inertia force sensor, the mass body composed of the free standing structure and the holding beams for holding the mass body can be fabricated by a single step using single crystal silicon. In this case, because the main process is performed by the wet etching technique, the manufacturing apparatus may be low-priced and it may be possible to process a plurality of silicon substrates at a stretch. In consequence, the inertia force sensor may have high reliability and may be low-priced.

Moreover, the height of each of the mass body and the holding beam can be controlled by the time for performing the etching, and further the rigidity of the holding beam can be adjusted without changing the mask. Therefore, it may be possible to fabricate inertia force sensors whose sensitivities are different from one another using the same mask. Further, because it is possible to enlarge the hollow portion below the free standing structure, there may not occur such a phenomenon that the structural portion (free standing structure) sticks to the substrate. In consequence, the yield in the manufacturing process may be highly improved.

In the inertia force sensor, the inertia force, which acts on the mass body, may be detected on the basis of a deflection of the holding beam, the deflection being caused by the movement of the mass body. In this case, because the measuring circuit, which measures the change of the resistance of the piezoresistor for detecting the deflection of the holding beam, is simplified, the inertia force sensor may be obtained at a low cost. Further, because the manufacturing process is simplified, the inertia force sensor with high reliability may be obtained while raising the yield.

If the inertia force sensor detects the inertia force which acts on the mass body in a direction parallel to a surface of the silicon substrate, the inertia force may be detected on the basis of capacitance (for example, electrostatic capacity, electric capacity) between a first cantilever supported by the mass body and a second cantilever supported by the anchor portion of the silicon substrate. In this case, because the movement of the mass body, within the plane of the substrate is detected as the change of the capacitance, the obtained inertia force sensor may have excellent sensitivity.

Further, if the inertia force sensor detects the inertia force which acts on the mass body in a direction perpendicular to a surface of the silicon substrate, the inertia force may be detected on the basis of capacitance between the mass body and a counter electrode provided on another surface of the silicon substrate, the electrode being joined with the silicon substrate. In this case, because the movement of the mass body, perpendicular to the plane of the substrate is detected as the change of the capacitance (for example, electrostatic capacity, electric capacity), the obtained inertia force sensor may have excellent sensitivity.

In the inertia force sensor, it is preferable that the anchor portion is provided with etching holes. In this case, because the free standing structure with the shape as same as that of etching start patterns and the continuous anchor portion can be fabricated, the inertia force sensor may have high reliability.

Meanwhile, in the inertia force sensor, the deflection of the holding beam may be detected on the basis of resistance of a piezoresistor disposed on at least one end side of the holding beam in a direction of the deflection of the holding beam. In this case, because the deflection of the holding beam is detected by the piezoresistor provided on the holding beam, the reading circuit is simplified so that the sensor may be obtained at a low cost. Moreover, if each of the both end sides of the holding beam is provided with the piezoresistor, the sensor acts as a functional type of inertia force sensor to detect the inertia force. In consequence, the sensitivity of the sensor may be highly improved by balancing the temperature dependency.

A method of manufacturing an inertia force sensor according to another aspect of the present invention, the sensor having a mass body which moves when force is applied to the sensor, at least one beam for holding the mass body and an anchor portion for fixing an end portion of the beam, and the sensor being designed to detect inertia force, which acts on the mass body, on the basis of a movement of the mass body, is characterized in that it includes (i) an etching start pattern forming step for forming etching start patterns on a silicon substrate or on a surface of the silicon substrate, (ii) a first etching step for etching the silicon substrate by applying a voltage to the silicon substrate to form etched portions that extend in a direction depthwise of the silicon substrate from the etching start patterns while the silicon substrate is immersed in a solution containing fluorine ions, with the silicon substrate used a positive electrode, and (iii) a second etching step for accelerating etching of the silicon substrate by increasing a current flowing through the silicon substrate after the etched portions have reached a predetermined depth, to thereby form a free standing structure composed of a part of the silicon substrate wherein each neighboring etched portions are communicated with each other at a location deeper than the predetermined depth, wherein (iv) the mass body is composed of the free standing structure and the anchor portion is composed of at least a portion of a main portion of the silicon substrate.

In the method of manufacturing the inertia force sensor, the mass body, which consists of the free standing structure composed of single crystal silicon and to which the inertia force is exerted, and the holding beams for holding the mass body can be fabricated by a single step, and further the main process is performed by the wet etching technique. Therefore, the manufacturing apparatus may be low-priced. Further, because it is possible to process a plurality of silicon substrates at a stretch, the obtained inertia force sensor may have high reliability and may be low-priced. Moreover, the height of each of the mass body and the holding beam can be controlled by the time for performing the etching, the rigidity of the holding beam may be adjusted without changing the mask. Therefore, it may be possible to fabricate inertia force sensors whose sensitivities are different from one another using the same mask. Further, because it is possible to enlarge the hollow portion below the free standing structure, there may not occur such a phenomenon that the structural portion (free standing structure) sticks to the substrate. In consequence, the yield in the manufacturing process may be highly improved.

In the method of manufacturing the inertia force sensor, it is preferable that etching holes are formed at a position of the silicon substrate where the anchor portion is to be formed, in the etching start pattern forming step. In this case, because the free standing structure with the shape as same as that of etching start patterns and the continuous anchor portion can be fabricated, the inertia force sensor may have high reliability.

Moreover, in the method of manufacturing the inertia force sensor, a continuous etching start pattern surrounding a block-shaped portion of the silicon substrate, which is to be removed, may be formed in the etching start pattern forming step, and further the portion to be removed may be removed from the main portion of the silicon substrate by an etching process in the second etching step. In this case, it is possible to remove any desired amount of silicon in any desired region. Therefore, a distance, in which the mass body and the holding beam can move when inertia force is exerted to the sensor, may be enlarged. In consequence, the sensitivity of the inertia force sensor may be raised, and further the degree of freedom in designing the inertia force sensor may be increased.

### Brief Description Of Drawings

Figs. 1A to 1J are sectional elevation views of a silicon substrate and intermediate inertia force sensors, respectively, which show a manufacturing process of an inertia force sensor according to the first embodiment of the present invention.
Fig. 2 is a perspective view of the inertia force sensor according to the first embodiment of the present invention.
Fig. 3 is a sectional elevation view of an etching apparatus which is used when the silicon substrate is etched in the manufacturing process of the inertia force sensor according to the first embodiment of the present invention.
Figs. 4A and 4B are sectional elevation views of further etching apparatuses which are used when the silicon substrate is etched in the manufacturing process of the inertia force sensor according to the first embodiment of the present invention.
Fig. 5 is a perspective view showing a boundary portion between a cantilever and an anchor portion of the inertia force sensor according to the first embodiment of the present invention.
Figs. 6A to 6J are sectional elevation views of a silicon substrate and intermediate inertia force sensors, respectively, which show a manufacturing process of an inertia force sensor according to the third embodiment of the present invention.
Fig. 7 is a sectional elevation view of an etching apparatus which is used when the silicon substrate is etched in the manufacturing process of the inertia force sensor according to the third embodiment of the present invention.
Fig. 8 is a sectional elevation view of another etching apparatus which is used when the silicon substrate is etched in the manufacturing process of the inertia force sensor according to the third embodiment of the present invention.
Fig. 9 is a perspective view showing a boundary portion between a cantilever and an anchor portion of an inertia force sensor according to the fourth embodiment of the present invention.
Fig. 10 is a perspective view showing a boundary portion between a cantilever and an anchor portion of an inertia force sensor according to the fifth embodiment of the present invention.
Fig. 11 is a perspective view showing a boundary portion between a cantilever and an anchor portion of an inertia force sensor according to the sixth embodiment of the present invention.
Fig. 12 is a plane view showing etching start patterns in a manufacturing process of an inertia force sensor according to the seventh embodiment of the present invention.
Figs. 13A to 13G are sectional elevation views of a silicon substrate and intermediate inertia force sensors, respectively, which show a manufacturing process of an inertia force sensor according to the eighth embodiment of the present invention.
Fig. 14 is a perspective view of the inertia force sensor according to the eighth embodiment of the present invention.
Figs. 15A to 15F are sectional elevation views of a silicon substrate and intermediate inertia force sensors, respectively, which show a manufacturing process of an inertia force sensor according to the ninth embodiment of the present invention.
Figs. 16A to 16D are sectional elevation views of a silicon substrate and intermediate inertia force sensors, respectively, which show the manufacturing process of the inertia force sensor according to the ninth embodiment of the present invention.
Figs. 17A to 17F are sectional elevation views of a silicon substrate and a silicon device on the way of manufacturing, respectively, which show a conventional manufacturing process of the silicon device having a free standing structure.
Figs. 18A to 18F are sectional elevation views of a silicon substrate and a silicon device on the way of manufacturing, respectively, which show a conventional groove forming step for forming grooves on the silicon substrate.

### Best Mode for Carrying Out the Invention

Hereinafter, embodiments of the present invention will be concretely described with reference to the accompanying drawings. Hereupon, in each of the accompanying drawings, like members or constructive elements are designated by like reference numerals. Further, in the present specification, the term of "intermediate inertia force sensor" means such a silicon substrate which is a raw material of an inertia force sensor, to which any processing has been performed in the manufacturing process of the inertia force sensor, but which has not been completed as a finished inertia force sensor yet.

### (The first embodiment)

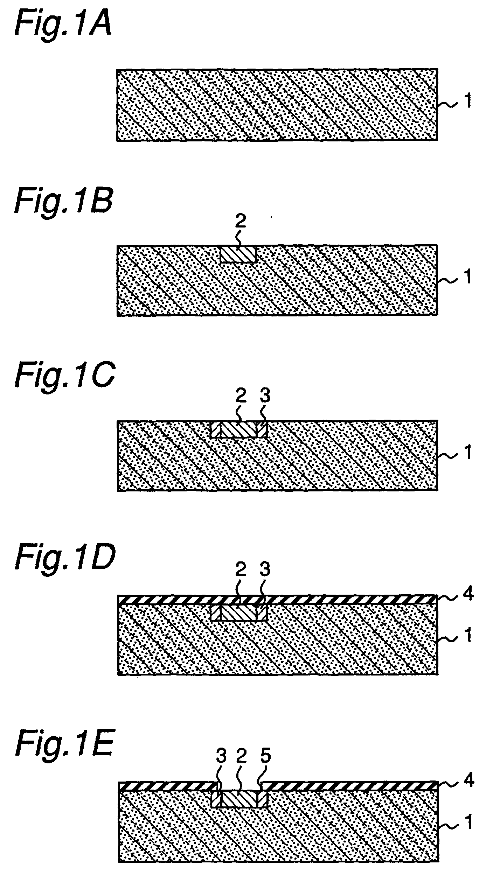

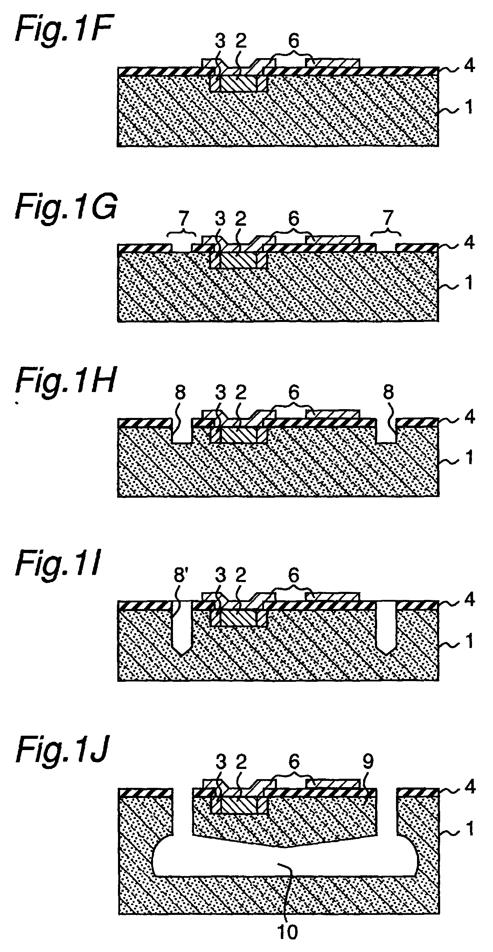

Figs. 1A to 1J show a manufacturing process of an inertia force sensor according to the first embodiment of the present invention. Hereinafter, the inertia force sensor or the manufacturing process thereof according to the first embodiment will be described with reference to those drawings.

In the manufacturing process of the inertia force sensor, at first, as shown in Fig. 1A, an n-type silicon substrate 1 of about 400 µm thickness is prepared. Further, as shown in Fig. 1B, a piezoresistor 2 is formed in a region of the silicon substrate 1, the region existing near the upper surface of the substrate. The piezoresistor 2 is formed by implanting boron into the region in the silicon substrate 1, which is to become the piezoresistor 2, with the accelerating voltage of 150KeV and the dose of 8 × 10¹³/cm². Following that, as shown in Fig. 1C, there is formed a highly boron-doped region 3 (region with boron of high concentration) for achieving electrical conductivity between the piezoresistor 2 and the electrical wiring. The highly boron-doped region 3 is formed by implanting boron ions into the both end sides of the piezoresistor 2, which has been formed already, with the accelerating voltage of 150KeV and the dose of 4.8 × 10¹⁵/cm². Further, an annealing treatment is performed at 980 °C for two hours.

Next, as shown in Fig. 1D, for example, a silicon nitride film 4 of about 0.1 µm thickness is formed on the silicon substrate 1, the piezoresistor 2 and the highly boron-doped region 3 by means of the CVD technique or the like. Following that, as shown in Fig. 1E, a portion of the silicon nitride film 4 covering the piezoresistor 2 and highly boron-doped region 3, both of which have been formed already, is removed by means of the plasma etching technique so that a contact hole 5 for achieving electrical conductivity is formed. Further, after chrome and gold have been successively deposited by evaporation onto the intermediate inertia force sensor (silicon substrate 1), it is immersed in a solution for wet etching. In consequence, the periphery portion of the contact hole 5, which has been formed already by removing the silicon nitride film 4, is gently sloped so that the electrical conductivity between the highly boron-doped region 3 and the chrome-gold is raised.

Further, as shown in Fig. 1F, after chrome and gold have been deposited by evaporation onto the whole surface of the intermediate inertia force sensor (silicon substrate 1) again, a wiring pattern 6 is formed by means of the photolithography technique. Then, as shown in Fig. 1G, the silicon nitride film 4, which has been formed already, is patterned by means of the photolithography technique or the like so that there is formed a mask 7 for the initial etching which is performed before the main etching. Next, as shown in Fig. 1H, the silicon substrate 1 is subjected to the initial etching process using the reactive ion etching technique so that etching start patterns 8 of about 3 µm depth are formed. Further, a voltage of about 3V is applied between the silicon substrate 1 and a counter electrode while the silicon substrate 1 (intermediate inertia force sensor) is immersed in a hydrofluoric acid aqueous solution of 5%, with the silicon substrate 1 used a positive electrode. Hereupon, light is applied to the back surface of the silicon substrate 1 using a halogen lamp of 150w, whose light intensity can be arbitrarily varied, so that the silicon substrate 1 is etched in the direction depthwise of the silicon substrate 1. On that occasion, the light intensity of the halogen lamp is adjusted so that the current density in the silicon substrate 1 is held at 32mA/cm². Meanwhile, as known in general, between the light intensity and the current density in the silicon substrate 1, there exists such a functional relation that the latter uniquely increases or decreases in accordance with the increase or decrease of the former. Thus, as shown in Fig. 1I, etched portions 8' (openings, grooves) formed under the etching start patterns 8 extend in the direction depthwise of the silicon substrate 1. Then, after the etched portions 8' have reached the desired depth, the current density in the silicon substrate 1 is increased to 60mA/cm² by increasing the light intensity of the halogen lamp. So, the etching process is performed for about ten minutes so that each neighboring etched surfaces (side walls of the etched portions) are communicated with each other (each neighboring etched portions are communicated with each other) in the lower part of the structure in the former step. In consequence, as shown in Fig. 1J, a single crystal free standing structure 9 (movable mass body) composed of a part of the silicon substrate 1 is formed, while a hollow portion 10 is formed below the free standing structure 9.

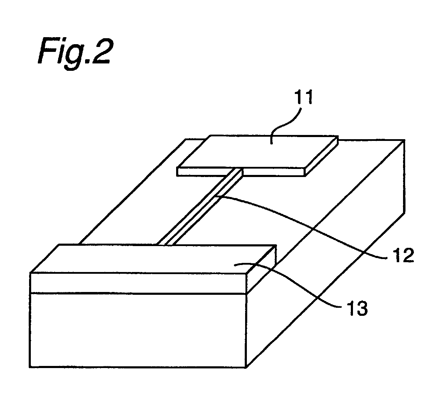

Fig. 2 is a perspective view showing the inertia force sensor manufactured by means of the manufacturing process shown in Figs. 1A to 1J. As shown in Fig. 2, the inertia force sensor is provided with a mass body of free standing structure 11 (movable mass body), a cantilever 12 for holding the mass body 11 and an anchor portion 13 for fixing the cantilever 12 to the substrate. Thus, in the inertia force sensor, when inertia force is exerted to the mass body 11, the cantilever 12 holding the mass body bends so that the resistance of the piezoresistor (not shown) formed on the cantilever changes. Consequently, on the basis of the resistance of the piezoresistor, the amount of the deflection of the cantilever 12, namely the inertia force exerted to the mass body 11 can be measured.

In the manufacturing process of the inertia force sensor according to the first embodiment, the depth of the hollow portion 10 can be set to any desired value by adjusting the time of etching process performed with the current density of 60mA/cm² as described above. Hereupon, it is preferable that the concentration of the hydrofluoric acid aqueous solution used as the etchant is set to a value in the range from 1% to 20%. That is, electropolishing may occur if the concentration of the hydrofluoric acid aqueous solution is lower than 1%, while if it is higher than 20%, it may be impossible to obtain a smooth etched surface, and further it may be difficult to obtain a desired device shape. Meanwhile, it is preferable that the applied voltage is set to a value lower than or equal to 10V. Because, when the applied voltage is higher than 10V, a local dielectric breakdown may occur so that it may be difficult to obtain a smooth etched surface and to obtain a desired shape of silicon device. Hereupon, the applied voltage described above does not mean the voltage outputted from the constant voltage power supply, but the voltage which is actually applied to the silicon substrate 1. Further, it is preferable that the sheet resistance of the n-type silicon substrate 1 is set to a value in the range from 0.1 Ω·cm to 50 Ω·cm. Because, it may be impossible to obtain the desired shape of silicon device in which a micro porous silicon structure is formed on the etched surface if the sheet resistance of the n-type silicon substrate 1 is lower than 0.1 Ω·cm, while it may be difficult to make the silicon device fine-shaped if it is higher than 50 Ω·cm. Hereupon, the depth of the initial etching does not affect the main etching which is to be performed following that. However, if the initial etching is not performed, the dimensional accuracy of the fabricated structural part is inferior in comparison with the case with the initial etching. Therefore, when the dimensional accuracy of the structure is required to be high, it is preferable that the initial etching is performed. Further, the initial thickness of the silicon substrate 1 does not affect the initial etching or the main etching which is to be performed following that. By the way, in the above-mentioned manufacturing process, when the free standing structure 9 is formed, the current density in the silicon substrate is increased by varying the light intensity of the halogen lamp. However, the same effects as described above may be obtained also, even if the current density is increased by varying the applied voltage.

In the inertia force sensor (silicon device) manufactured by means of the manufacturing process according to the first embodiment, because the free standing structure 9 is formed of single crystal silicon, the inertia force sensor may have excellent mechanical properties and high reliability. Further, because it is possible to make the hollow portion 10 below the free standing structure 9 larger, the free standing structure 9 does not stick to the plate-shaped substrate thereunder. In consequence, its yield may be highly improved. Moreover, according to the manufacturing process of the inertia force sensor, the movable portion composed of the free standing structure can be fabricated in a single step. Consequently, the manufacturing process may be simplified so that the inertia force sensor may be obtained at a low cost. Further, because the reactive ion etching technique used for the initial etching is not affected by the crystal orientation of the silicon substrate 1, the etching start patterns 8 can be formed on the silicon substrate 1 in any desired shape. In consequence, the free standing structure 9 fabricated in the following etching process also can have any desired shape so that the obtained inertia force sensor structure may have an excellent performance.

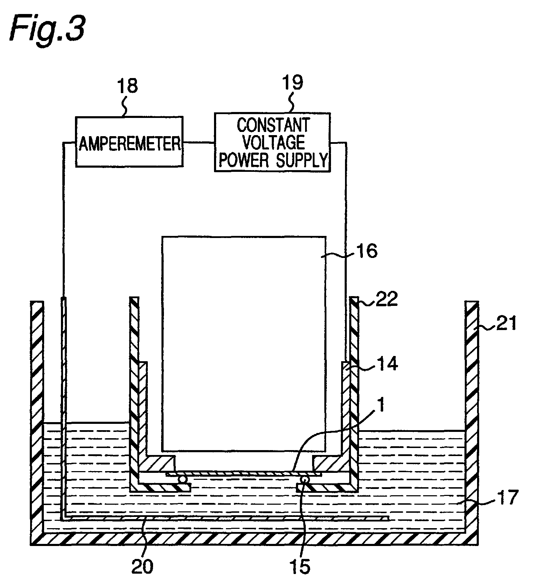

Fig. 3 shows an etching apparatus which is used when the free standing structure is formed in the silicon substrate, in the manufacturing process of the inertia force sensor according to the first embodiment of the present invention. As shown in Fig. 3, the etching apparatus is provided with a silicon substrate holder 14 for holding the n-type silicon substrate 1 to which the etching is performed, and further achieving electrical conductivity between the silicon substrate 1 and the apparatus. The silicon substrate holder 14 is, for example, made of copper. Further, the etching apparatus is provided with an O-ring 15 having an excellent chemical resistance for preventing etchant 17 from leaking into the inner space of the silicon substrate holder 14, a light source 16 for producing pairs of electrons and positive holes in the silicon substrate 1, an amperemeter 18, a constant voltage power supply 19, and a counter electrode 20 made of noble metal such as platinum or the like. Moreover, the etching apparatus is provided with a vessel 21 for containing the etchant 17, which is, for example, made of teflon or the like, and an outer frame 22 for protecting the silicon substrate holder 14 against the etchant 17. Hereupon, the outer frame 22 is, for example, made of teflon or the like.

In the etching apparatus, if a surface active agent or the like is added to the etchant 17, hydrogen produced during the etching process is easy to be released from the surface of the silicon substrate 1 so that the uniformity of the etching in the silicon substrate 1 may be improved. Further, if the contact resistance between the silicon substrate holder 14 and the silicon substrate 1 is lowered by implanting ions to the back side of the silicon substrate 1 and further forming a film of aluminum etc., for example, using a sputter apparatus, the etching process is stabilized so that the etching in the silicon substrate 1 may be uniformed. Consequently, the obtained inertia force sensor may have high reliability. In addition, if an adhesive including silver particles is applied between the silicon substrate holder 14 and the silicon substrate 1, the contact resistance may be further lowered so that the above-mentioned effects may be raised.

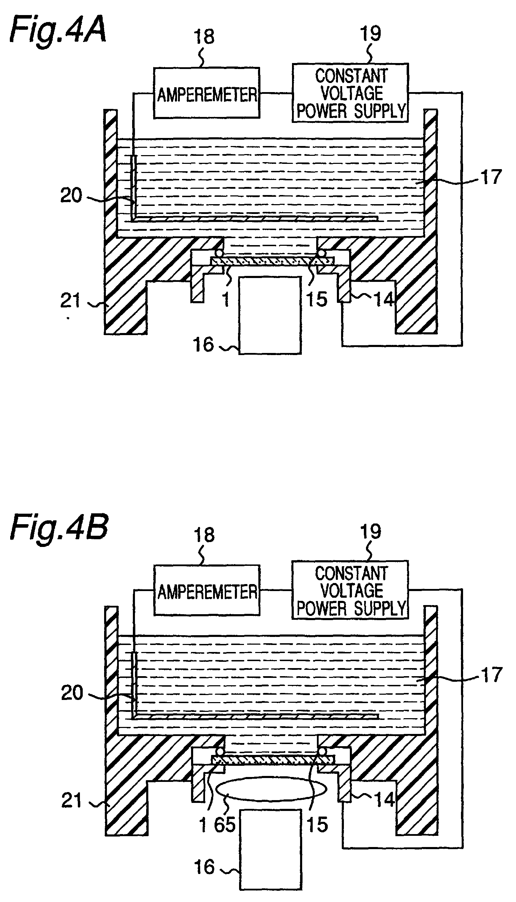

Fig. 4A shows another etching apparatus which is used when the free standing structure is formed in the silicon substrate, in the manufacturing process of the inertia force sensor according to the first embodiment of the present invention. The etching apparatus shown in Fig. 3 has such a construction that the spreading surface of the silicon substrate 1, to which the etching is performed, is directed downward and etched by the etchant 17 existing thereunder, while the light source 16 is disposed above the silicon substrate 1. On the other hand, the etching apparatus shown in Fig. 4A has such a construction that the spreading surface of the silicon substrate 1, to which the etching is performed, is directed upward and etched by the etchant 17 existing thereon, while the light source 16 is disposed under the silicon substrate 1. In the etching apparatus shown in Fig. 4A, during the etching process, bubbles produced near the spreading surface of the silicon substrate 1, to which the etching is performed, is facilitated to move upward, namely in the direction apart from the surface of the silicon substrate, by the buoyancy. In consequence, the bubbles are very easy to be released from the silicon substrate 1 so that the uniformity of the etching in the silicon substrate 1 may be improved much more.

Meanwhile, as shown in Fig. 4B, a lens 65 may be disposed between the silicon substrate 1 and the light source 16 in the construction of the etching apparatus shown in Fig. 4A. In this case, because the light intensity within the silicon substrate 1 can be uniformed, the structural part formed in the silicon substrate is also uniformed so that the obtained inertia force sensor may have higher reliability.

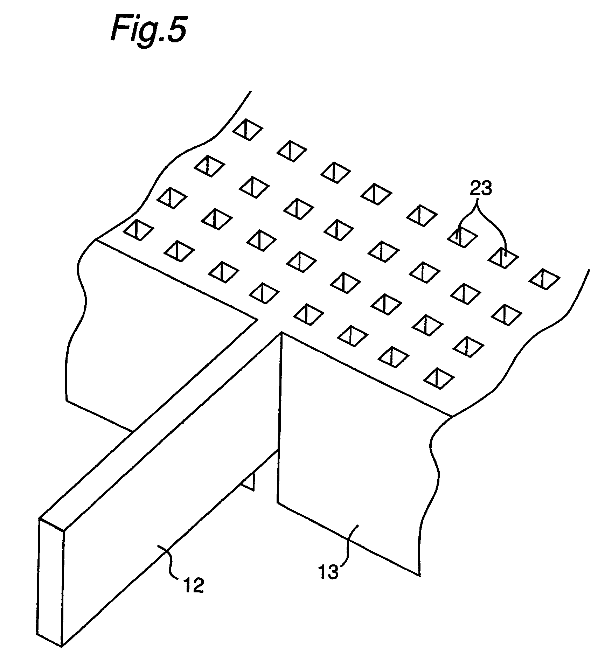

Fig. 5 shows a boundary portion (clamping portion) between a cantilever 12 and an anchor portion 13 for fixing the cantilever to the silicon substrate 1 (main portion). As shown in Fig. 5, if etching holes 23 are provided on a part of the anchor portion 13, the part existing at a position near the boundary between the cantilever 12 for supporting the mass body and the anchor portion 13 for fixing the cantilever to the silicon substrate 1, excessive positive holes are consumed by the above-mentioned etching holes 23. Consequently, over etching is not caused in the boundary portion between the anchor portion 13 and the cantilever 12 so that the obtained fix end may have high reliability.

### (The second embodiment)

Hereinafter, a manufacturing process of a silicon device (inertia force sensor) according to the second embodiment will be described. However, the manufacturing process of the inertia force sensor according to the second embodiment has many things in common with the manufacturing process of the inertia force sensor according to the first embodiment shown in Figs. 1A to 1J. Thus, Figs. 1A to 1J also conform to the second embodiment. Therefore, it will be described with reference to Figs. 1A to 1J, hereinafter.

In the manufacturing process of the inertia force sensor according to the second embodiment, as shown in Figs. 1A to 1H, on an n-type silicon substrate 1, there are formed or fabricated a piezoresistor 2, a highly boron-doped region 3, a silicon nitride film 4, a contact hole 5, a wiring pattern 6, a mask 7 and etching start patterns 8, using a process similar to the manufacturing process of the inertia force sensor according to the first embodiment.

Further, a voltage of about 3V is applied between the silicon substrate 1 and a counter electrode while the silicon substrate 1 (intermediate inertia force sensor) is immersed in an ammonium fluoride aqueous solution of 5%, with the silicon substrate 1 used a positive electrode. Hereupon, light is applied to the back surface of the silicon substrate 1 using a halogen lamp of 150w, whose light intensity can be arbitrarily varied, so that the silicon substrate 1 is etched in the direction depthwise of the substrate. On that occasion, the light intensity of the halogen lamp is adjusted so that the current density in the silicon substrate 1 is held at 32mA/cm². Thus, as shown in Fig. 1I, etched portions 8' (openings, grooves) formed under the etching start patterns 8 extend in the direction depthwise of the silicon substrate 1. Then, after the etched portions 8' formed by the etching have reached the desired depth, the current density in the silicon substrate 1 is increased to 60mA/cm² by increasing the light intensity of the halogen lamp. So, the etching process is performed for about ten minutes so that each neighboring etched surfaces (side walls of the etched portions) are communicated with each other (each neighboring etched portions are communicated with each other) in the lower part of the structure formed in the former step. In consequence, as shown in Fig. 1J, a single crystal free standing structure 9 composed of a part of the silicon substrate 1 is formed, while a hollow portion 10 is formed below the free standing structure 9.

In the manufacturing process, the depth of the hollow portion 10 can be set to any desired value by adjusting the time of etching process performed with the current density of 60mA/cm² as described above. Hereupon, it is preferable that the concentration of the ammonium fluoride aqueous solution used as the etchant is set to a value in the range from 1% to 20%. That is, electropolishing may occur if the concentration of the ammonium fluoride aqueous solution is lower than 1%, while if it is higher than 20%, it may be impossible to obtain a smooth etched surface, and further it may be difficult to obtain a desired device shape. Meanwhile, it is preferable that the applied voltage is set to a value lower than or equal to 10V. Because, when the applied voltage is higher than 10V, a local dielectric breakdown may occur so that it may be difficult to obtain a smooth etched surface and to obtain a desired shape of silicon device. Hereupon, the applied voltage does not mean the voltage outputted from the constant voltage power supply, but the voltage which is actually applied to the silicon substrate 1. Further, it is preferable that the sheet resistance of the n-type silicon substrate 1 is set to a value in the range from 0.1 Ω·cm to 50 Ω·cm. Because, it may be impossible to obtain the desired shape of silicon device in which a micro porous silicon structure is formed on the etched surface if the sheet resistance of the n-type silicon substrate 1 is lower than 0.1 Ω·cm, while it may be difficult to make the silicon device fine-shaped if it is higher than 50 Ω·cm. Hereupon, the procedure and depth of the initial etching do not affect the main etching which is to be performed following that. However, if the initial etching is not performed, the dimensional accuracy of the fabricated structural part is inferior in comparison with the case with the initial etching. Therefore, when the dimensional accuracy of the structure is required to be high, it is preferable that the initial etching is performed. Further, the initial thickness of the silicon substrate 1 does not affect the initial etching or the main etching which is to be performed following that. Hereupon, the same effects as described above may be obtained also, even if the current density is varied by increasing the applied voltage when the current density in the silicon substrate 1 is increased in order to fabricate the free standing structure. Meanwhile, the main etching process may be performed using the etching apparatus shown in Fig. 3, 4A or 4B.

In the inertia force sensor (silicon device) manufactured by means of the manufacturing process according to the second embodiment, because the free standing structure 9 is formed of single crystal silicon, the inertia force sensor may have excellent mechanical properties and high reliability. Further, because it is possible to make the hollow portion 10 below the free standing structure 9 larger, the free standing structure 9 does not stick to the plate-shaped substrate thereunder. In consequence, its yield may be highly improved. Moreover, because the movable portion composed of the free standing structure can be fabricated in one single step, the manufacturing process may be simplified so that the inertia force sensor may be manufactured at a low cost. Further, because the ion beam etching technique used for the initial etching is not affected by the crystal orientation of the silicon substrate 1, the etching start patterns can be formed on the silicon substrate 1 in any desired shape. In consequence, the free standing structure 9 fabricated in the following etching process also can have any desired shape so that the obtained inertia force sensor structure may have an excellent performance.

Moreover, in the manufacturing process, because the ammonium fluoride aqueous solution is used as the etchant, the aluminum wiring, to which silicon is doped, is hardly damaged when the main etching process is performed. In consequence, the process may be in harmony with the conventional process for the CMOS semiconductor. Therefore, before the main etching is performed, the circuit for reading the change of the piezoresistance may be easily provided on the same substrate of the inertia force sensor.

Hereupon, in the second embodiment, if the etching holes 23 are provided on a part of the anchor portion 13, the part existing at a position near the boundary between the cantilever 12 for supporting the mass body 11 and the anchor portion for fixing the cantilever 12 to the silicon substrate as same as the case of the first embodiment, excessive positive holes are consumed by the etching holes 23. Consequently, over etching is not caused in the boundary portion between the anchor portion 13 and the cantilever 12 so that the obtained fix end may have high reliability (see Fig. 5).

### (The third embodiment)

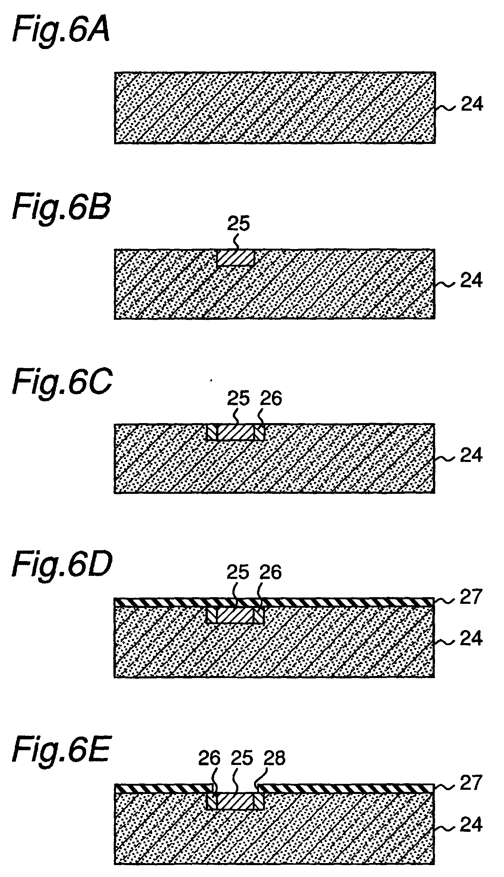

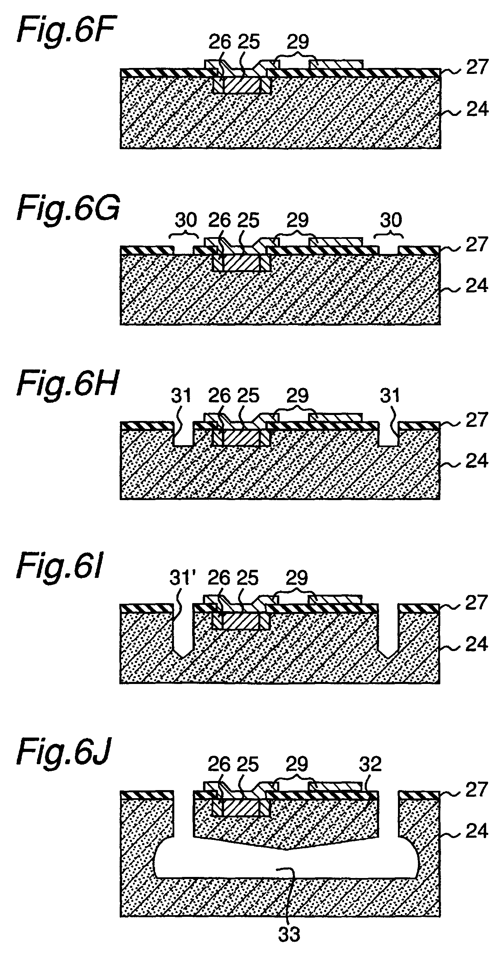

Figs. 6A to 6J show a manufacturing process of an inertia force sensor according to the third embodiment of the present invention. Hereinafter, the inertia force sensor or the manufacturing process thereof according to the third embodiment will be described with reference to those drawings.

In the manufacturing process of the inertia force sensor, at first, as shown in Fig. 6A, a p-type silicon substrate 24 of about 400 µm thickness is prepared. Further, as shown in Fig. 6B, a piezoresistor 25 is formed in a region of the silicon substrate 24, the region existing near the upper surface of the substrate. The piezoresistor 25 is formed by implanting, for example, arsenic which is one of n-type materials into the region in the silicon substrate 24, which is to become the piezoresistor 25, with the accelerating voltage of 150KeV and the dose of 8 × 10¹³/cm². Following that, as shown in Fig. 6C, there is formed a highly arsenic-doped region 26 (region with arsenic of high concentration) for achieving electrical conductivity between the piezoresistor 25 and the electrical wiring. The highly arsenic-doped region 26 is formed by implanting arsenic ions into the both end sides of the piezoresistor 25, which has been formed already, with the accelerating voltage of 150KeV and the dose of 4.8 × 10¹⁵/cm². Further, an annealing treatment is performed at 980 °C for two hours.

Next, as shown in Fig. 6D, for example, a silicon nitride film 27 of about 0.1 µm thickness is formed on the silicon substrate 24, the piezoresistor 25 and the highly arsenic-doped region 26 by means of the CVD technique or the like. Following that, as shown in Fig. 6E, a portion of the silicon nitride film 27 covering the piezoresistor 25 and highly arsenic-doped region 26, both of which have been formed already, is removed by means of the plasma etching technique so that a contact hole 28 for achieving electrical conductivity is formed. Further, after chrome and gold have been successively deposited by evaporation onto the intermediate inertia force sensor (silicon substrate 24), it is immersed in a solution for wet etching. In consequence, the periphery portion of the contact hole 28, which has been formed already by removing the silicon nitride film 27, is gently sloped so that the electrical conductivity between the highly arsenic-doped region 26 and the chrome-gold is raised.

Further, as shown in Fig. 6F, after chrome and gold have been deposited by evaporation onto the whole surface of the intermediate inertia force sensor (silicon substrate 24) again, a wiring pattern 29 is formed by means of the photolithography technique. Then, as shown in Fig. 6G, the silicon nitride film 27, which has been formed already, is patterned by means of the photolithography technique or the like so that there is formed a mask 30 for the initial etching which is performed before the main etching. Next, as shown in Fig. 6H, the silicon substrate is subjected to the initial etching process using the reactive ion etching technique so that etching start patterns 31 of about 3 µm depth are formed. Further, a voltage of about 3V is applied between the silicon substrate 24 and a counter electrode to etch the silicon substrate 24 in the direction depthwise of the substrate while the silicon substrate 24 (intermediate inertia force sensor) is immersed in an organic solution which contains hydrofluoric acid by 5%, water by 5% and dimethylformamide as the remainder, with the silicon substrate 24 used a positive electrode. On that occasion, the voltage outputted from the power supply is adjusted so that the current density in the silicon substrate 24 is held at 26mA/cm².

Thus, as shown in Fig. 6I, etched portions 31' (openings, grooves) formed under the etching start patterns 31 extend in the direction depthwise of the silicon substrate 24. Then, after the etched portions 31' formed by the etching have reached the desired depth, the current density in the silicon substrate 24 is increased to 40mA/cm² by increasing the voltage applied by the power supply. So, the etching process is performed for about ten minutes so that each neighboring etched surfaces (side walls of the etched portions) are communicated with each other (each neighboring etched portions are communicated with each other) in the lower part of the structure formed in the former step. In consequence, as shown in Fig. 6J, a single crystal free standing structure 32 composed of a part of the silicon substrate 24 is formed, while a hollow portion 33 is formed below the free standing structure 32. Hereupon, the depth of the hollow portion 33 can be set to any desired value by adjusting the time of etching process performed with the current density of 40mA/cm² as described above.

Meanwhile, in the third embodiment also, if the etching holes 23 are provided on a part of the anchor portion 13, the part existing at a position near the boundary between the cantilever 12 for supporting the mass body 11 and the anchor portion for fixing the cantilever 12 to the silicon substrate as same as the case of the first embodiment, excessive positive holes are consumed by the etching holes 23. Consequently, over etching is not caused in the boundary portion between the anchor portion 13 and the cantilever 12 so that the obtained fix end may have high reliability (see Fig. 5).

Hereupon, if an ammonium fluoride solution of 5% is used as the etchant instead of the organic solution containing hydrofluoric acid, aluminum to which a little amount of silicon is doped, can be used for the wiring instead of chrome and gold so that the process may be in harmony with the conventional process for the CMOS semiconductor. In consequence, before the main etching is performed, the circuit for reading the change of the piezoresistance may be easily provided on the same substrate of the inertia force sensor.

In the manufacturing process, it is preferable that the concentration of hydrofluoric acid in the solution used as the etchant is set to a value in the range from 1% to 20%. That is, electropolishing may occur if the concentration of hydrofluoric acid is lower than 1%, while if it is higher than 20%, it may be impossible to obtain a smooth etched surface, and further it may be difficult to obtain a desired device shape. Meanwhile, it is preferable that the applied voltage is set to a value lower than or equal to 10V. Because, when the applied voltage is higher than 10V, a local dielectric breakdown may occur so that it may be difficult to obtain a smooth etched surface and to obtain a desired shape of silicon device. Hereupon, the applied voltage does not mean the voltage outputted from the power supply, but the voltage which is actually applied to the silicon substrate 24. Further, it is preferable that the sheet resistance of the p-type silicon substrate 24 is set to a value in the range from 0.01 Ω·cm to 500 Ω·cm. Because, it may be impossible to obtain the desired shape of silicon device in which a micro porous silicon structure is formed on the etched surface if the sheet resistance of the p-type silicon substrate 24 is lower than 0.01 Ω·cm, while it may be difficult to make the silicon device fine-shaped if it is higher than 500 Ω·cm.

In the inertia force sensor (silicon device) manufactured by means of the manufacturing process according to the third embodiment, because the free standing structure 32 is formed of single crystal silicon, the inertia force sensor or silicon device may have excellent mechanical properties and high reliability. Further, because it is possible to make the hollow portion 33 below the free standing structure 32 larger, the free standing structure 32 does not stick to the plate-shaped substrate thereunder. In consequence, its yield may be highly improved. Moreover, the free standing structure 32 of the above shape can be fabricated in a single step. Consequently, the manufacturing process may be simplified so that the inertia force sensor may be manufactured at a low cost. Further, because the reactive ion etching technique used for the initial etching is not affected by the crystal orientation of the silicon substrate 24, the etching start patterns 31 can be formed on the silicon substrate 24 in any desired shape. In consequence, the free standing structure 32 fabricated in the following etching process also can have any desired shape so that the obtained inertia force sensor structure may have an excellent performance.

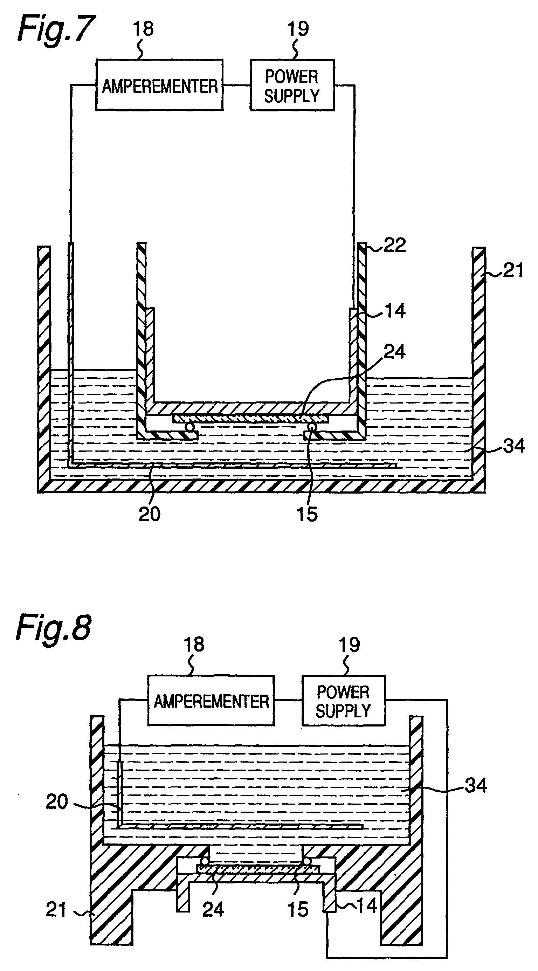

Fig. 7 shows an etching apparatus which is used when the main etching is performed in the manufacturing process of the inertia force sensor according to the third embodiment of the present invention. Hereupon, the above-mentioned etching apparatus has many things in common with the etching apparatus according to the first embodiment shown in Fig. 3. Therefore, in order to prevent duplicate descriptions, only things different from those of the etching apparatus shown in Fig. 3 will be described below. That is, as shown in Fig. 7, the etching apparatus according to the third embodiment is not provided with the light source 16 of the first embodiment (see Fig. 3). Further, the composition of the etchant 34 is different from that of the first embodiment. Moreover, the silicon substrate 24 is p-type one in contrast with the first embodiment. In addition, the output voltage of the power supply 19 is varied to adjust the current density in the silicon substrate 24, in contrast with the first embodiment. Other constructions or functions of the etching apparatus shown in Fig. 7 are as same as those of the etching apparatus shown in Fig. 3 according to the first embodiment.

In the etching apparatus, if a surface active agent or the like is added to the etchant 34, hydrogen produced during the etching process is easy to be released from the surface of the silicon substrate, and further the wettability between the etched surface and the etchant is improved. Consequently, the uniformity of the etching in the silicon substrate 24 may be improved. Hereupon, even if acetonitrile is used instead of dimethylformamide, the same effects may be obtained. Further, even if ammonium fluoride is used instead of hydrofluoric acid, the same effects may be obtained. Moreover, as same as the case of the first embodiment, if the contact resistance between the silicon substrate holder 14 and the silicon substrate 24 is lowered by implanting ions to the back side of the silicon substrate 24 and further forming a film of aluminum etc., for example, using a sputter apparatus, the etching process is stabilized so that the etching in the silicon substrate 24 may be uniformed. Consequently, the obtained silicon device (inertia force sensor) may have high reliability. In addition, if an adhesive including silver particles is applied between the silicon substrate holder 14 and the silicon substrate 24, the contact resistance may be further lowered so that the above-mentioned effects may be raised.

Fig. 8 shows another etching apparatus which is used when the main etching is performed in the manufacturing process of the inertia force sensor according to the third embodiment of the present invention. The etching apparatus shown in Fig. 7 has such a construction that the spreading surface of the silicon substrate 24, to which the etching is performed, is directed downward and etched by the etchant 34 existing thereunder. On the other hand, the etching apparatus shown in Fig. 8 has such a construction that the spreading surface of the silicon substrate 24, to which the etching is performed, is directed upward and etched by the etchant 34 existing thereon. In the etching apparatus shown in Fig. 8, during the etching process, bubbles produced near the spreading surface of the silicon substrate 24, to which the etching is performed, is facilitated to move upward, namely in the direction apart from the surface of the silicon substrate, by the buoyancy. In consequence, the bubbles are very easy to be released from the silicon substrate 24 so that the uniformity of the etching in the silicon substrate 24 may be improved much more.

As described above, when the p-type silicon substrate 24 is used, there exist many positive holes in the silicon substrate 24, the holes being required for the main etching. Therefore, it is not necessary to produce pairs of electrons and positive holes by applying light to the back surface of the silicon substrate 24. In consequence, it is not required to provide a light source so that the etching apparatus may be obtained at a low cost. Further, because ununiformity of the main etching due to ununiformity of the light intensity is excluded, the inertia force sensor or silicon device may have high reliability.

### (The fourth embodiment)

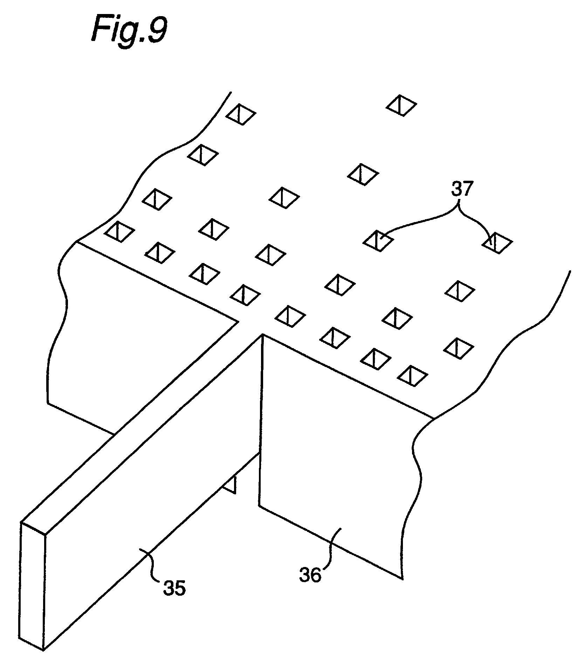

Fig. 9 shows a boundary portion between a beam 35 and an anchor portion 36, in an inertia force sensor according to the fourth embodiment of the present invention. As shown in Fig. 9, in the inertia force sensor, the anchor portion 36 is provided with etching holes 37, each of which has a square shape with 2 µm sides (2 µm × 2 µm square). As apparent from Fig. 9, the distribution density of the etching holes 37 is gradually lowered from the fix end portion side of the beam 35 to the inner side of the anchor portion 36. In this case, the change of the current density at the fix end portion of the beam 35 is further lowered so that over etching at the fix end portion may be prevented. In the inertia force sensor according to the fourth embodiment, because over etching is not caused at the fix end portion as described above, its reliability may be highly improved.

### (The fifth embodiment)

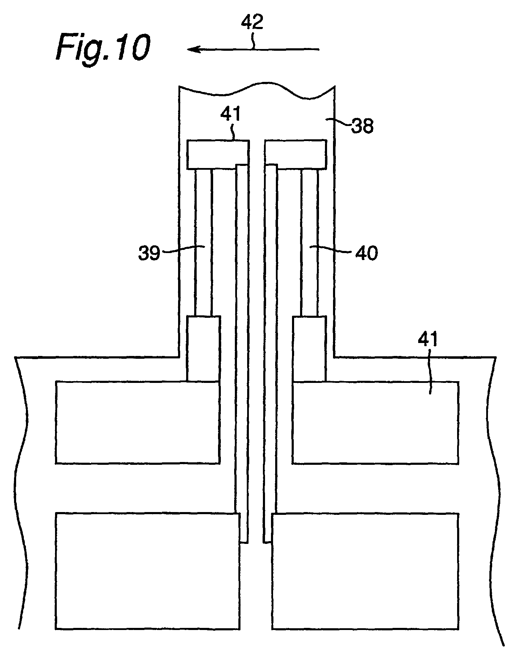

Fig. 10 is a view showing a boundary portion between a beam and an anchor portion (fix end portion), in an inertia force sensor according to the fifth embodiment of the present invention. As shown in Fig. 10, the inertia force sensor is provided with a single cantilever 38, two piezoresistors 39,40 formed by means of the doping process in the manufacturing process shown in Figs. 1A to 1J (the first embodiment), and wiring patterns 41 for achieving electrical conductivity.

In the inertia force sensor, the piezoresistors 39,40 are formed at both side portions of the cantilever 38, respectively. Thus, when inertia force is exerted to the mass body (not shown), the cantilever 38 bends. On that occasion, if the cantilever 38 bends in the direction of the arrow 42, compressive stress is caused in the piezoresistor 39 while tensile stress is caused in the piezoresistor 40. Hereupon, if the difference between the value detected by the piezoresistor 39 and the value detected by the piezoresistor 40 is used, the output values become twice as large as those of the case that one piezoresistor is disposed at only one side portion of the cantilever 38. Further, because outputs due to temperature change and disturbance are reduced (eliminated), the sensitivity of the inertia force sensor may be improved, as well as the reliability of the sensor may be improved.

### (The sixth embodiment)

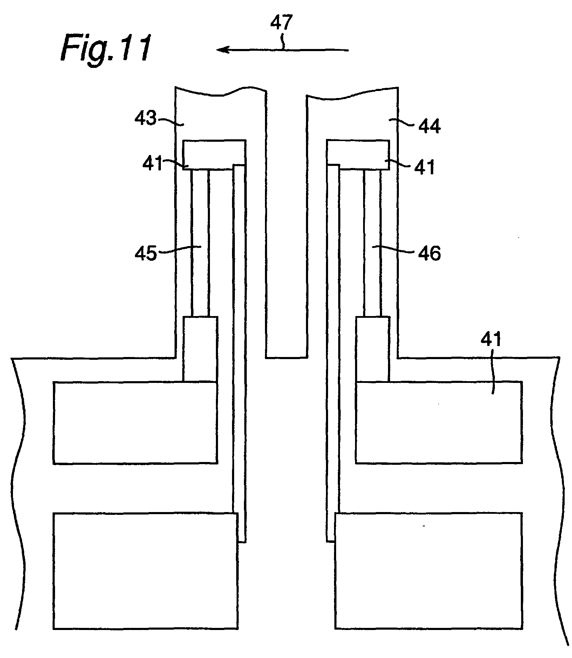

Fig. 11 is a view showing a boundary portion between a beam and an anchor portion (fix end portion), in an inertia force sensor according to the sixth embodiment of the present invention. As shown in Fig. 11, the inertia force sensor is provided with two cantilevers 43,44, two piezoresistors 45,46 formed by means of the doping process in the manufacturing process shown in Figs. 1A to 1J (the first embodiment), and wiring patterns 41 for achieving electrical conductivity.

In the inertia force sensor, at one side portion of each of the two cantilevers 43,44, the respective piezoresistor 45,46 is formed. Thus, when inertia force is exerted to the mass body (not shown), the cantilevers 43,44 bend together. On that occasion, if the cantilevers 43,44 bend in the direction of the arrow 47, compressive stress is caused in the piezoresistor 45 while tensile stress is caused in the piezoresistor 46. Hereupon, if the difference between the value detected by the piezoresistor 45 and the value detected by the piezoresistor 46 is used, the output values become twice as large as those of the case that one piezoresistor is disposed at one side portion of either of the cantilevers 43,44. Further, because outputs due to temperature change and disturbance are reduced (eliminated), the sensitivity of the inertia force sensor may be improved, as well as the reliability of the sensor may be improved.

### (The seventh embodiment)

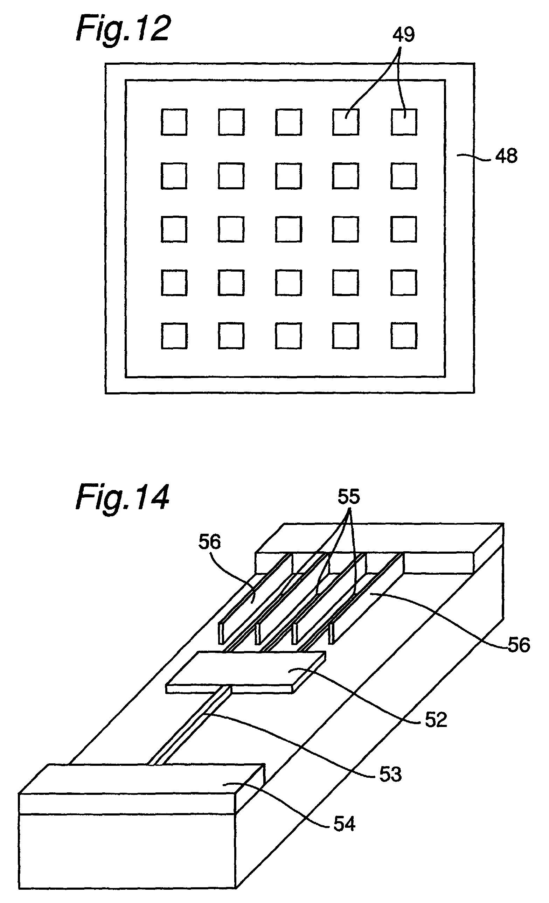

Fig. 12 is a view showing etching start patterns in a mass body (movable mass body) and around the body, of an inertia force sensor according to the seventh embodiment of the present invention. In the inertia force sensor, the etching start patterns are formed by means of the manufacturing process shown in Figs. 1A to 1J (the first embodiment). As shown in Fig. 12, a continuous pattern 48 of square-strip shape is formed around the region to be removed, while there are formed holes 49 within the continuous pattern, each of the holes 49 having an opening with square shape of 2 µm sides (2 µm × 2 µm square). Thus, they are used as the etching patterns. If the free standing structure is fabricated by performing the main etching using the above-mentioned etching start patterns in accordance with the manufacturing process shown in Figs. 1A to 1J, the square region corresponding to the pattern 48 shown in Fig. 12 may be removed. Hereupon it is preferable that the length of the side of each of the etching holes in the region to be removed is set to a value in the range from 1 µm to 8 µm. If the length of the side of the etching hole is smaller than 1 µm or larger than 8 µm, the local current density is not uniformed. In consequence, it is impossible to form uniform etching holes so that the reliability may be lowered.

According to the etching technique, because the etching start patterns are formed by means of the reactive ion etching technique which is not affected by the crystal orientation of the silicon substrate, the etching start patterns may be formed in any desired shapes. In consequence, it is possible to remove any desired amount of material in any desired region so that the degree of freedom in designing may be increased.

### (The eighth embodiment)

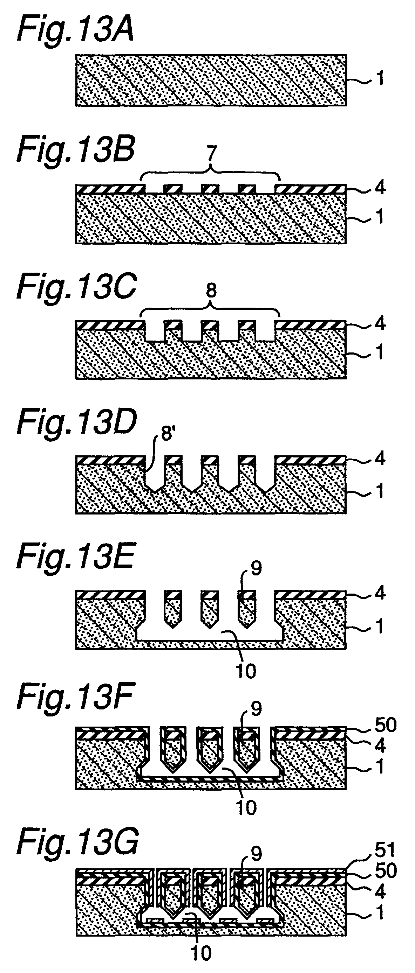

Figs. 13A to 13G show a manufacturing process of an inertia force sensor according to the eighth embodiment of the present invention. Hereinafter, the inertia force sensor or the manufacturing process thereof according to the eighth embodiment will be described with reference to those drawings.

In the manufacturing process of the inertia force sensor, at first, as shown in Fig. 13A, an n-type silicon substrate 1 of about 400 µm thickness is prepared. Further, as shown in Fig. 13B, after a silicon nitride film 4, for example, of about 0.3 µm thickness has been formed on the silicon substrate 1 by means of the sputter technique or the like, the silicon nitride film 4 is patterned by means of the photolithography technique or the like so that there is formed a mask 7 for the initial etching which is performed before the main etching. Following that, as shown in Fig. 13C, the silicon substrate is subjected to the initial etching process using the reactive ion etching technique so that etching start patterns 8 of about 3 µm depth are formed.

Next, a voltage of about 3V is applied between the silicon substrate 1 and a counter electrode while the silicon substrate 1 is immersed in a hydrofluoric acid aqueous solution of 5%, with the silicon substrate 1 used a positive electrode. Hereupon, light is applied to the back surface of the silicon substrate 1 using a halogen lamp of 150w, whose light intensity can be arbitrarily varied, so that the silicon substrate 1 is etched in the direction depthwise of the silicon substrate 1. On that occasion, the light intensity of the halogen lamp is adjusted so that the current density in the silicon substrate 1 is held at 26mA/cm². Thus, as shown in Fig. 13D, etched portions 8' are formed. After the etched portions 8' have reached the desired depth, the current density in the silicon substrate 1 is increased to 40mA/cm² by increasing the light intensity of the halogen lamp. So, the etching process is performed for about ten minutes so that each neighboring etched surfaces are communicated with each other in the lower part of the structure formed in the former step. Consequently, as shown in Fig. 13E, a single crystal free standing structure 9 composed of a part of the silicon substrate 1 is fabricated, while a hollow portion 10 is formed below the free standing structure 9. Further, as shown in Fig. 13F, a silicon nitride film 50 of 1 µm thickness is formed as an electrically insulating film using the LPCVD technique or the like. Then, as shown in Fig. 13G, there is formed an aluminum electrode, to which a small amount of silicon is doped, or wiring material 51, which is a film state of 0.3 µm thickness, for example, using the sputter technique.

Hereupon, the depth of the hollow portion 10 can be set to any desired value by adjusting the time of etching process performed with the current density of 40mA/cm² as described above. Meanwhile, it is preferable that the concentration of the hydrofluoric acid aqueous solution used as the etchant is set to a value in the range from 1% to 20%. That is, electropolishing may occur if the concentration of the hydrofluoric acid aqueous solution is lower than 1%, while if it is higher than 20%, it may be impossible to obtain a smooth etched surface, and further it may be difficult to obtain a desired device shape. Further, it is preferable that the applied voltage is set to a value lower than or equal to 10V. Because, when the applied voltage is higher than 10V, a local dielectric breakdown may occur so that it may be difficult to obtain a smooth etched surface and to obtain a desired shape of silicon device. Hereupon, the applied voltage does not mean the voltage outputted from the constant voltage power supply, but the voltage which is actually applied to the silicon substrate 1. Moreover, it is preferable that the sheet resistance of the n-type silicon substrate 1 is set to a value in the range from 0.1 Ω·cm to 50 Ω·cm. Because, it may be impossible to obtain the desired shape of silicon device in which a micro porous silicon structure is formed on the etched surface if the sheet resistance of the n-type silicon substrate 1 is lower than 0.1 Ω·cm, while it may be difficult to make the silicon device fine-shaped if it is higher than 50 Ω·cm. Hereupon, the depth of the initial etching does not affect the main etching which is to be performed following that. However, if the initial etching is not performed, the dimensional accuracy of the fabricated structural part is inferior in comparison with the case with the initial etching. Therefore, when the dimensional accuracy of the structure is required to be high, it is preferable that the initial etching is performed. Further, the initial thickness of the silicon substrate 1 does not affect the initial etching or the main etching which is to be performed following that. Hereupon, the same effects as described above may be obtained also, even if the current density is varied by increasing the applied voltage when the current density in the silicon substrate 1 is increased in order to fabricate the free standing structure.

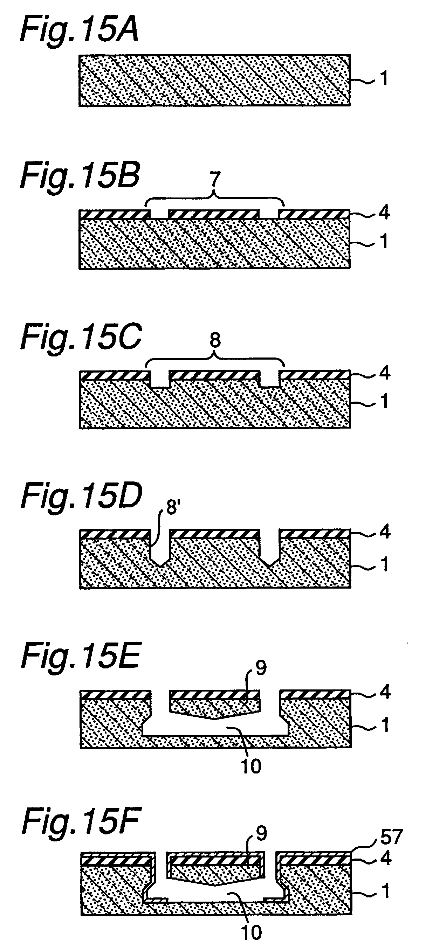

Fig. 14 is a perspective view of the inertia force sensor manufactured by means of the manufacturing process according to the eighth embodiment. As shown in Fig. 14, the inertia force sensor is provided with a mass body 52 (movable mass body) of a free standing structure, a cantilever 53 for holding the mass body 52, an anchor portion 54 for fixing the cantilever 53 to the substrate, free standing structure beams 55 joined with the mass body 52, and counter electrodes 56 fixed to the substrate. In the inertia force sensor, when inertia force is exerted to the mass body 52, the cantilever 53 supporting the body bends, so that the free standing structure beams 55 joined with the mass body 52 move. In consequence, the capacitance between the free standing structure beams 55 and the counter electrodes 56 formed on the substrate changes, so that the inertia force exerted to the mass body 52 can be measured on the basis of the change of the capacitance.

In the inertia force sensor manufactured by means of the manufacturing process according to the eighth embodiment, because the free standing structure 9 is formed of single crystal silicon, the inertia force sensor may have excellent mechanical properties and high reliability. Further, because it is possible to make the hollow portion 10 below the free standing structure 9 larger, the free standing structure 9 does not stick to the plate-shaped substrate thereunder. In consequence, its yield may be highly improved. Moreover, because the movable portion composed of the free standing structure can be fabricated in one single step, the manufacturing process may be simplified so that the inertia force sensor may be manufactured at a low cost. Further, because the reactive ion etching technique used for the initial etching is not affected by the crystal orientation of the silicon substrate 1, the etching start patterns can be formed on the silicon substrate 1 in any desired shape. In consequence, the free standing structure fabricated in the following etching process also can have any desired shape so that the obtained inertia force sensor structure may have an excellent performance.

### (The ninth embodiment)

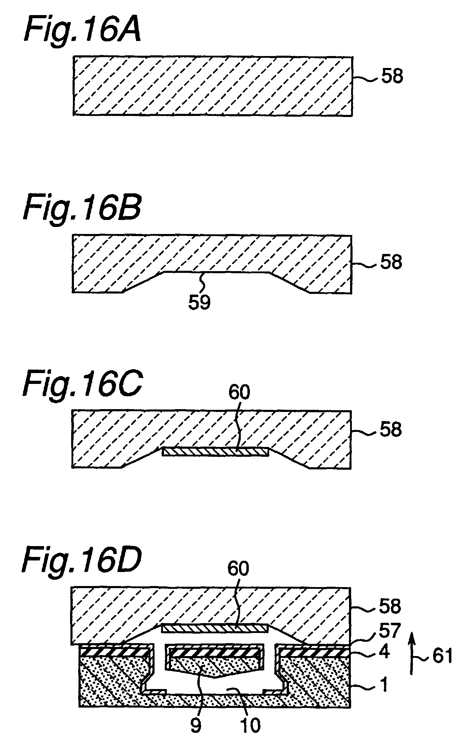

Figs. 15A to 15F and Figs. 16A to 16D show a manufacturing process of an inertia force sensor according to the ninth embodiment of the present invention. Hereinafter, the inertia force sensor or the manufacturing process thereof according to the ninth embodiment will be described with reference to those drawings.

In the manufacturing process of the inertia force sensor, at first, as shown in Fig. 15A, an n-type silicon substrate 1 of about 400 µm thickness is prepared. Further, as shown in Fig. 15B, after a silicon nitride film 4, for example, of about 0.3 µm thickness has been formed on the silicon substrate 1 by means of the sputter technique or the like, the silicon nitride film 4 is patterned by means of the photolithography technique or the like so that there is formed a mask 7 for the initial etching which is performed before the main etching. Following that, as shown in Fig. 15C, the silicon substrate is subjected to the initial etching process using the reactive ion etching technique so that etching start patterns 8 of about 3 µm depth are formed.

Next, a voltage of about 3V is applied between the silicon substrate 1 and a counter electrode while the silicon substrate 1 is immersed in a hydrofluoric acid aqueous solution of 5%, with the silicon substrate 1 used a positive electrode. Hereupon, light is applied to the back surface of the silicon substrate 1 using a halogen lamp of 150w, whose light intensity can be arbitrarily varied, so that the silicon substrate 1 is etched in the direction depthwise of the silicon substrate 1. On that occasion, the light intensity of the halogen lamp is adjusted so that the current density in the silicon substrate 1 is held at 26mA/cm². Thus, as shown in Fig. 15D, etched portions 8' are formed. After the etched portions 8' have reached the desired depth, the current density in the silicon substrate 1 is increased to 40mA/cm² by increasing the light intensity of the halogen lamp. So, the etching process is performed for about ten minutes so that each neighboring etched surfaces are communicated with each other in the lower part of the structure formed in the former step. Consequently, as shown in Fig. 15E, a single crystal free standing structure 9 composed of a part of the silicon substrate 1 is fabricated, while a hollow portion 10 is formed below the free standing structure 9. Further, as shown in Fig. 15F, aluninum to which a small amount of silicon is doped, is deposited on the substrate to form a film of about 0.2 µm thickness, for example, using the sputter technique, the film composing wiring 57 and an electrode 57 for the free standing structure 9.

In parallel with the above, as shown in Fig. 16A, a glass substrate 58 is prepared. Further, as shown in Fig. 16B, a gap 59 (concave portion) of 5 µm depth is formed on the glass substrate 58 using hydrofluoric acid. Moreover, as shown in Fig. 16C, an aluminum film of 0.2 µm thickness, to which a small amount of silicon is doped, is formed on the bottom surface of the gap 59 by means of the sputter technique, the film composing a counter electrode 60 of the mass body 9. Then, as shown in Fig. 16D, the substrate 1, in which the free standing structure 9 is formed, and the glass substrate 58, on which the gap 59 is formed, are joined with each other.

Hereupon, the depth of the hollow portion can be set to any desired value by adjusting the time of etching process performed with the current density of 40mA/cm² as described above. Meanwhile, it is preferable that the concentration of the hydrofluoric acid aqueous solution used as the etchant is set to a value in the range from 1% to 20%. That is, electropolishing may occur, if the concentration of the hydrofluoric acid aqueous solution is lower than 1%, while if it is higher than 20%, it may be impossible to obtain a smooth etched surface, and further it may be difficult to obtain a desired device shape. Further, it is preferable that the applied voltage is set to a value lower than or equal to 10V. Because, when the applied voltage is higher than 10V, a local dielectric breakdown may occur so that it may be difficult to obtain a smooth etched surface and to obtain a desired shape of silicon device. Hereupon, the applied voltage does not mean the voltage outputted from the constant voltage power supply, but the voltage which is actually applied to the silicon substrate. Moreover, it is preferable that the sheet resistance of the n-type silicon substrate 1 is set to a value in the range from 0.1 Ω·cm to 50 Ω·cm. Because, it may be impossible to obtain the desired shape of silicon device in which a micro porous silicon structure is formed on the etched surface if the sheet resistance of the n-type silicon substrate 1 is lower than 0.1 Ω·cm, while it may be difficult to make the silicon device fine-shaped if it is higher than 50 Ω·cm. Hereupon, the depth of the initial etching does not affect the main etching which is to be performed following that. However, if the initial etching is not performed, the dimensional accuracy of the fabricated structural part is inferior in comparison with the case with the initial etching. Therefore, when the dimensional accuracy of the structure is required to be high, it is preferable that the initial etching is performed. Further, the initial thickness of the silicon substrate does not affect the initial etching or the main etching which is to be performed following that. Hereupon, the same effects as described above may be obtained also, even if the current density is varied by increasing the applied voltage when the current density in the silicon substrate 1 is increased in order to fabricate the free standing structure.

In Fig. 16D, when inertia force is exerted to the mass body 9 in the direction of the arrow 61, the mass body 9 held by the cantilever moves in the direction of the arrow 61. In consequence, the capacitance formed by the mass body 9 and the glass substrate 58 changes so that the inertia force exerted to the mass body 9 can be measured.

In the inertia force sensor manufactured by means of the manufacturing process according to the ninth embodiment, because the free standing structure 9 is formed of single crystal silicon, the inertia force sensor may have excellent mechanical properties and high reliability. Further, because it is possible to make the hollow portion 10 below the free standing structure 9 larger, the free standing structure 9 does not stick to the plate-shaped substrate thereunder. In consequence, its yield may be highly improved. Moreover, according to the manufacturing process of the inertia force sensor, the movable portion composed of the free standing structure can be fabricated in one single step. Consequently, the manufacturing process is simplified so that the inertia force sensor may be manufactured at a low cost. Further, because the reactive ion etching technique used for the initial etching is not affected by the crystal orientation of the silicon substrate 1, the etching start patterns can be formed on the silicon substrate 1 in any desired shape. In consequence, the free standing structure fabricated in the following etching process also can have any desired shape so that the obtained inertia force sensor structure may have an excellent performance. In addition, because the movement of the mass body is detected as the change of the capacitance between the mass body 9 and the glass substrate 58, the obtained inertia force sensor may have excellent sensitivity.

### Industrial Applicability

As described above, the inertia force sensor or the manufacturing process thereof according to the present invention is useful as an inertia force sensor for detecting acceleration, angular velocity or the like, and particularly suitable for using as a sensor for a car body controller, a safety apparatus or the like, of an automobile.

## Claims

1. An inertia force sensor comprising:
a mass body which moves when force is applied to said sensor;
at least one holding beam for holding said mass body; and
an anchor portion for fixing an end portion of said holding beam, said sensor being designed to detect inertia force, which acts on said mass body, on the basis of a movement of said mass body, wherein
said mass body is composed of a free standing structure which is formed by removing an inner part of a silicon substrate therefrom by means of an etching process, and said anchor portion is composed of at least a part of a main body of said silicon substrate.

2. The inertia force sensor according to claim 1, wherein said inertia force, which acts on said mass body, is detected on the basis of a deflection of said holding beam, said deflection being caused by the movement of said mass body.

3. The inertia force sensor according to claim 1, wherein said inertia force, which acts on said mass body in a direction parallel to a surface of said silicon substrate, is detected on the basis of capacitance between a first cantilever supported by said mass body and a second cantilever supported by said anchor portion of said silicon substrate.

4. The inertia force sensor according to claim 1, wherein said inertia force, which acts on said mass body in a direction perpendicular to a surface of said silicon substrate, is detected on the basis of capacitance between said mass body and a counter electrode provided on another surface of said silicon substrate, said electrode being joined with said silicon substrate.

5. The inertia force sensor according to claim 1, wherein said anchor portion is provided with etching holes.

6. The inertia force sensor according to claim 2, wherein said deflection of said holding beam is detected on the basis of resistance of a piezoresistor disposed on at least one end side of said holding beam in a direction of said deflection of said holding beam.

7. A method of manufacturing an inertia force sensor having a mass body which moves when force is applied to said sensor, at least one beam for holding said mass body and an anchor portion for fixing an end portion of said beam, said sensor being designed to detect inertia force, which acts on said mass body, on the basis of a movement of said mass body, said method comprising:
an etching start pattern forming step for forming etching start patterns on a silicon substrate or on a surface of said silicon substrate;
a first etching step for etching said silicon substrate by applying a voltage to said silicon substrate to form etched portions that extend in a direction depthwise of said silicon substrate from said etching start patterns while said silicon substrate is immersed in a solution containing fluorine ions, with said silicon substrate used a positive electrode; and
a second etching step for accelerating etching of said silicon substrate by increasing a current flowing through said silicon substrate after said etched portions have reached a predetermined depth, to thereby form a free standing structure composed of a part of said silicon substrate wherein each neighboring etched portions are communicated with each other at a location deeper than the predetermined depth, wherein
said mass body is composed of said free standing structure and said anchor portion is composed of at least a portion of a main portion of said silicon substrate.

8. The method of manufacturing the inertia force sensor according to claim 7, wherein etching holes are formed at a position of said silicon substrate where said anchor portion is to be formed, in said etching start pattern forming step.

9. The method of manufacturing the inertia force sensor according to claim 7, wherein a continuous etching start pattern surrounding a block-shaped portion of said silicon substrate, which is to be removed, is formed in said etching start pattern forming step, and further said portion to be removed is removed from said main portion of said silicon substrate by an etching process in said second etching step.
